# FASCICULE DE BREVET EUROPEEN

(11) **EP 3 811 419 B1**
(45) Date de publication et mention de la délivrance du brevet: **03.08.2022**
(21) Numéro de dépôt: 19790601.9
(22) Date de dépôt: 18.06.2019
(51) Int. Cl.: H01L 33/08, H01L 33/18, H01L 21/762

(54) **PROCÉDÉ DE FABRICATION D'UN DISPOSITIF OPTOÉLECTRONIQUE À DIODES ÉLECTROLUMINESCENTES**
VERFAHREN ZUR HERSTELLUNG EINES OPTOELEKTRONISCHEN BAUTEILS MIT LEUCHTDIODEN
MANUFACTURING METHOD OF AN OPTOELECTRONIC DEVICE WITH LIGHT-EMITTING DIODES

(30) Priorité: 19.06.2018 FR 1855368
(43) Date de publication de la demande: 28.04.2021
(73) Titulaire: Aledia, 38130 Echirolles (FR); Commissariat à l'Energie Atomique et aux Energies Alternatives, 75015 Paris (FR)
(72) Inventeur: BEIX, Vincent, 73000 CHAMBERY (FR); LACAVE, Thomas, 38000 GRENOBLE (FR); VOLPERT, Marion, 38054 GRENOBLE CEDEX 09 (FR); GIRARD, Olivier, 38054 GRENOBLE CEDEX 09 (FR); RENAUD, Denis, 38054 GRENOBLE CEDEX 09 (FR); SOULIER, Brigitte, 38054 GRENOBLE CEDEX 09 (FR)
(74) Mandataire: Cabinet Beaumont
(86) Numéro de dépôt international: PCT/FR2019/051489
(87) Numéro de publication internationale: WO 2019/243733

(56) Documents cités:
- WO-A1-2017/109415
- WO-A2-2015/044621
- FR-A1- 3 023 066
- US-B1- 6 791 155

## Description

La présente demande de brevet revendique la priorité de la demande de brevet français FR18/55368.

### Domaine

La présente invention concerne de façon générale les dispositifs optoélectroniques à base de matériaux semiconducteurs et leurs procédés de fabrication. La présente invention concerne plus particulièrement les dispositifs optoélectroniques comprenant des diodes électroluminescentes formées par des éléments tridimensionnels, notamment des microfils ou nanofils semiconducteurs.

### Exposé de l'art antérieur

Par dispositifs optoélectroniques à diodes électroluminescentes, on entend des dispositifs adaptés à effectuer la conversion d'un signal électrique en un rayonnement électromagnétique, et notamment des dispositifs dédiés à l'émission d'un rayonnement électromagnétique, notamment de la lumière. Des exemples d'éléments tridimensionnels adaptés à la réalisation de diodes électroluminescentes sont des microfils ou nanofils comprenant un matériau semiconducteur à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI. Ces éléments tridimensionnels sont formés sur un substrat, par exemple un substrat semiconducteur.

Il est souhaitable de pouvoir commander séparément des ensembles de diodes électroluminescentes, voire des diodes électroluminescentes individuelles, qui sont formées sur le même substrat. Toutefois, cela peut conduire à un dispositif ayant une structure complexe.

WO 2015/044621 A2 décrit un tel dispositif optoélectronique et un procédé de manufacture correspondant.

### Résumé

Ainsi, un objet d'un mode de réalisation est que les dispositifs optoélectroniques à diodes électroluminescentes en matériau semiconducteur puissent être fabriqués à une échelle industrielle et à bas coût.

Un mode de réalisation prévoit également un procédé de fabrication d'un dispositif optoélectronique selon la revendication 1, et comprenant les étapes suivantes :
former un substrat ayant des première et deuxième faces opposées ;
former des tranchées d'isolation s'étendant dans le substrat de la première face à la deuxième face, entourant des portions du substrat et isolant électriquement les portions les unes des autres, chaque tranchée d'isolation étant remplie d'au moins un bloc isolant électriquement et d'un volume gazeux ou étant remplie d'un élément conducteur électriquement isolé électriquement du substrat ;
former au moins une diode électroluminescente reposant sur la première face pour chaque portion du substrat, les diodes électroluminescentes comprenant des éléments semiconducteurs filaires, coniques ou tronconiques ;
former une couche d'électrode recouvrant au moins l'une des diodes électroluminescentes et une couche conductrice recouvrant la couche d'électrode autour des diodes électroluminescentes ; et
former une couche encapsulant les diodes électroluminescentes et recouvrant toute la première face.

Selon un mode de réalisation, le procédé comprend les étapes successives suivantes :
a) prévoir le substrat comportant la première face ;
b) former en partie les tranchées d'isolation dans le substrat depuis la première face, les tranchées à l'étape b) ne traversant pas complètement le substrat ;
c) former des diodes électroluminescentes reposant sur la première face ;
d) former la couche d'électrode recouvrant au moins l'une des diodes électroluminescentes et la couche conductrice recouvrant la couche d'électrode autour des diodes électroluminescentes ;
e) recouvrir la totalité de la première face de la couche encapsulant les diodes électroluminescentes ; et
f) réduire l'épaisseur du substrat, le substrat comprenant, après l'étape f), la deuxième face opposée à la première face, les tranchées d'isolation s'étendant, après l'étape f), de la première face à la deuxième face et entourant les portions du substrat et isolant électriquement les portions les unes des autres.

Selon un mode de réalisation, le procédé comprend, avant l'étape b), pour chaque tranchée d'isolation, la gravure d'une ouverture dans le substrat depuis la première face sur une partie de l'épaisseur du substrat, l'ouverture étant ouverte sur la deuxième face à l'étape f).

Selon un mode de réalisation, chaque tranchée d'isolation comprend des faces latérales, le procédé comprenant la formation d'une couche isolante électriquement recouvrant les faces latérales.

Selon un mode de réalisation, chaque tranchée d'isolation est au moins partiellement remplie par ledit au moins un bloc isolant électriquement, ledit au moins un bloc isolant électriquement et la couche isolante électriquement étant constitués de matériaux différents.

Selon un mode de réalisation, chaque tranchée d'isolation comprend ledit élément conducteur électriquement, les éléments conducteurs électriquement étant électriquement reliés, du côté de la première face, à la couche d'électrode ou à la couche conductrice, le procédé comprenant la formation, sur la deuxième face, de deuxièmes plots électriquement conducteurs reliés électriquement aux éléments électriquement conducteurs.

Selon une alternative ne faisant pas partie de l'invention telle que revendiquée, le procédé comprend les étapes successives suivantes :
graver dans le substrat, du côté de la deuxième face, des ouvertures aux emplacements des tranchées d'isolation ; et
former, dans les ouvertures, les blocs isolants électriquement.

Selon un mode de réalisation, le procédé comprend une étape de fixation d'un support à la couche encapsulant les diodes électroluminescentes.

Selon un mode de réalisation, le procédé comprend la formation, pour chaque portion du substrat, d'au moins un premier plot conducteur reposant sur la deuxième face et en contact avec la portion du substrat.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 et 2 sont respectivement une vue en coupe et une vue de dessus, partielles et schématiques, d'un mode de réalisation , ne faisant pas partie de l'invention telle que revendiquée, d'un dispositif optoélectronique à diodes électroluminescentes ;
les figures 3 à 5 sont des vues de dessus, partielles et schématiques, d'autres modes de réalisation , ne faisant pas partie de l'invention telle que revendiquée, d'un dispositif optoélectronique à diodes électroluminescentes ;
les figures 6A à 6F sont des coupes, partielles et schématiques, de structures obtenues à des étapes successives d'un mode de réalisation , ne faisant pas partie de l'invention telle que revendiquée, d'un procédé de fabrication du dispositif optoélectronique représenté en figure 1 ;
les figures 7A à 7G sont des coupes, partielles et schématiques, de structures obtenues à des étapes successives d'un mode de réalisation selon l'invention d'un procédé de fabrication du dispositif optoélectronique représenté en figure 3 ;
les figures 8A à 8G sont des coupes, partielles et schématiques, de structures obtenues à des étapes successives d'un mode de réalisation selon l'invention d'un procédé de fabrication du dispositif optoélectronique représenté en figure 4 ; et
les figures 9A à 9E sont des coupes, partielles et schématiques, de structures obtenues à des étapes successives d'un mode de réalisation, ne faisant pas partie de l'invention telle que revendiquée, d'un procédé de fabrication du dispositif optoélectronique représenté en figure 5.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ", et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente description concerne des dispositifs optoélectroniques à éléments tridimensionnels, par exemple des microfils, des nanofils, des éléments coniques ou des éléments tronconiques. Dans la suite de la description, des modes de réalisation sont décrits pour des dispositifs optoélectroniques à microfils ou à nanofils. Toutefois, ces modes de réalisation peuvent être mis en oeuvre pour des éléments tridimensionnels autres que des microfils ou des nanofils, par exemple des éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

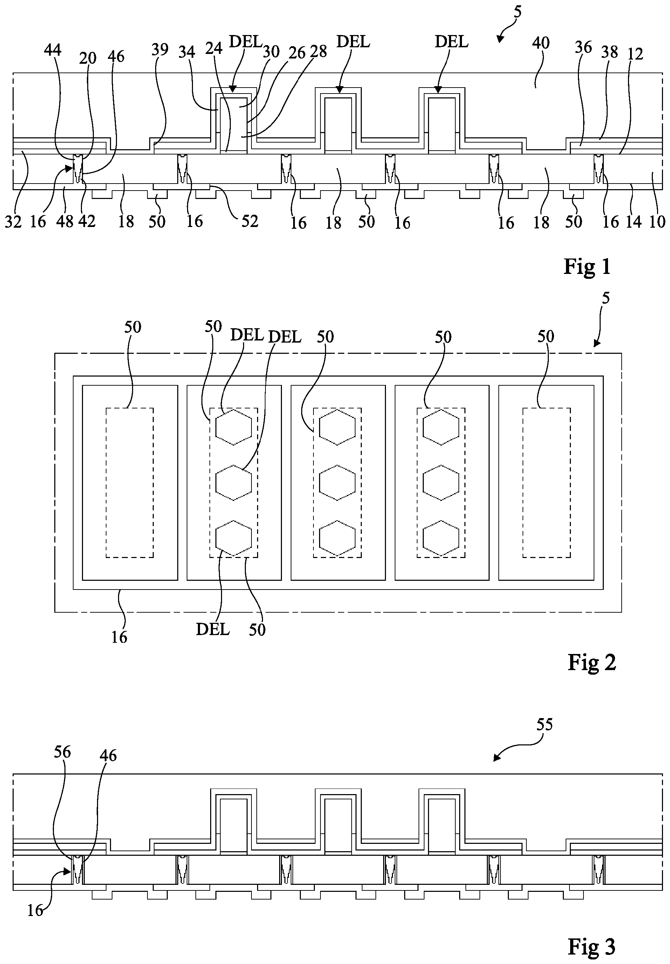

Les figures 1 et 2 sont respectivement une vue en coupe et une vue de dessus, partielles et schématiques, d'un mode de réalisation , ne faisant pas partie de l'invention telle que revendiquée, d'un dispositif optoélectronique 5. Le dispositif optoélectronique 5 comprend un substrat 10 ayant une face avant 12 et une face arrière 14 opposée à la face avant 12. Le dispositif optoélectronique 5 comprend des tranchées 16 d'isolation électrique qui s'étendent sur toute l'épaisseur du substrat 10. Les tranchées 16 entourent complètement des portions 18 du substrat 10 et isolent électriquement latéralement les portions 18 du substrat 10. Chaque tranchée 16 comprend une ouverture 20 traversant le substrat 10 de la face avant 12 à la face arrière 14 du substrat 10 et entourant l'une des portions 18 du substrat 10.

Le dispositif optoélectronique 5 comprend en outre :
des plots de germination 24 favorisant la croissance de fils et disposés sur la face 12 ;
des fils 26, chaque fil 26 étant en contact avec l'un des plots de germination 24, chaque fil 26 comprenant une portion inférieure 28, en contact avec le plot de germination 24 et une portion supérieure 30, prolongeant la portion inférieure 28 ;
une couche isolante 32 s'étendant sur la face 12 du substrat 10 et sur les flancs latéraux de la portion inférieure 28 de chaque fil 26 ;
une coque 34 comprenant un empilement de couches semiconductrices recouvrant chaque portion supérieure 30 ;
une couche 36 formant une première électrode recouvrant chaque coque 30 et s'étendant, en outre, sur la couche isolante 32 ;
une couche conductrice 38 recouvrant la couche d'électrode 36 entre les fils 26 mais ne s'étendant pas sur les fils 26 et venant au contact de portions 18 du substrat 10 aux travers d'ouvertures 39 prévues dans les couches 36 et 32 ; et
une couche d'encapsulation 40 sur la totalité du substrat 10.

La couche d'électrode 36, la couche conductrice 38 et la couche d'encapsulation 40 ne sont pas représentées en figure 2.

A titre de variante, pour chaque fil 26, la coque 34 peut recouvrir tout ou partie de la portion inférieure 28 du fil 26, la coque 34 étant interposée entre la couche isolante 32 et la portion inférieure 28 du fil 26.

L'ensemble formé par chaque fil 26, le plot de germination 24 et la coque 34 associés constitue une diode électroluminescente DEL. La base de la diode DEL correspond au plot de germination 24. La coque 34 comprend notamment une couche active qui est la couche depuis laquelle est émise la majorité du rayonnement électromagnétique fourni par la diode électroluminescente DEL.

Au moins une diode électroluminescente DEL est formée sur chaque portion 18 du substrat 10, trois diodes électroluminescentes étant représentées sur chaque portion 18 de substrat 10 en figure 2. Le nombre de diodes électroluminescentes DEL par portion 18 du substrat 10 peut varier de 1 à 100000.

Selon un mode de réalisation, chaque ouverture 20 est en partie remplie d'au moins un bloc 42 en un matériau isolant électriquement et en partie remplie d'un mélange gazeux 44, à la pression atmosphérique ou selon un vide partiel, c'est-à-dire à une pression comprise entre 10⁻⁸ Pa et 10⁵ Pa. Le bloc ou les blocs 42 recouvrent au moins en partie les parois latérales internes 46 de la tranchée 16.

A titre d'exemple, chaque ouverture 20 a une largeur comprise entre 300 nm et 10 µm. L'épaisseur du substrat 10 aminci est comprise entre 100 nm et 200 µm. Le rapport entre la profondeur et la largeur de chaque ouverture 20 (la profondeur de chaque ouverture 20 étant égale à l'épaisseur du substrat 10 aminci) est compris entre 3 et 100.

Le dispositif optoélectronique 5 comprend une couche isolante électriquement 48 recouvrant la face arrière 14 du substrat 10 aminci. La couche isolante 48 peut être interrompue au niveau d'au moins certaines des tranchée 16 lorsque le volume gazeux 44 de la tranchée 16 est ouvert sur la face arrière 14. Le dispositif optoélectronique 5 comprend, en outre, des plots conducteurs électriquement 50 dans des ouvertures 52 formées dans la couche isolante 48. Les plots conducteurs 50 sont représentés en traits pointillées en figure 2.

La couche isolante 48 peut recouvrir au moins en partie le pourtour de chaque plot conducteur 50. Les plots conducteurs 50 sont en contact avec la face arrière 14 du substrat 10. La couche isolante 48 est dans le même matériau que le bloc isolant 42.

Un avantage du présent mode de réalisation est que les contraintes mécaniques dues aux blocs isolants 42 des tranchées 16 sont réduites étant donné que les blocs isolants 42 ne remplissent pas complètement les tranchées 16. En outre, le volume gazeux 44 constitue un matériau sans contrainte mécanique, extensible et qui assure une isolation électrique.

Le substrat 10 peut correspondre à une structure monobloc ou correspondre à une couche recouvrant un support constitué d'un autre matériau. Le substrat 10 est, par exemple, un substrat semiconducteur, de préférence un substrat semiconducteur compatible avec les procédés de fabrication mis en oeuvre en microélectronique, par exemple un substrat en silicium, en germanium ou un alliage de ces composés. Le substrat est dopé de façon que la résistivité du substrat soit inférieure à quelques mohm.cm. De préférence, le substrat 10 est un substrat semiconducteur, tel qu'un substrat en silicium. Le substrat 10 peut être dopé d'un premier type de conductivité, par exemple dopé de type N. La face 12 du substrat 20 peut être une face <100> ou <111>.

Le matériau isolant composant les blocs 42 et la couche isolante 48 peut être choisi parmi le groupe comprenant l'oxyde de silicium (SiO₂), l'oxynitrure de silicium (SiON), le nitrure de silicium (SiN), le nitrure d'aluminium (AlN), l'oxyde de titane (TiO₂), l'oxyde d'aluminium (Al₂O₃), les matériaux organiques isolants électriquement, par exemple le parylène ou la résine ALX et les mélanges d'au moins deux de ces composés. Un avantage de l'utilisation de parylène est que ce matériau n'entraîne pas la génération de fortes contraintes mécaniques dans le dispositif optoélectronique 5. Selon un mode de réalisation, l'épaisseur de la couche isolante 48 est comprise entre 1 nm et 0,5 µm.

Les plots de germination 24, appelés également îlots de germination, sont en un matériau favorisant la croissance des fils 26. A titre de variante, les plots de germination 24 peuvent être remplacés par une couche de germination recouvrant la face 12 du substrat 10. Dans le cas de plots de germination, un traitement peut, en outre, être prévu pour protéger les flancs latéraux des plots de germination et la surface des parties du substrat non recouvertes par les plots de germination pour empêcher la croissance des fils sur les flancs latéraux des plots de germination et sur la surface des parties du substrat non recouvertes par les plots de germination. Le traitement peut comprendre la formation d'une région diélectrique sur les flancs latéraux des plots de germination et s'étendant sur et/ou dans le substrat et reliant, pour chaque paire de plots, l'un des plots de la paire à l'autre plot de la paire, les fils ne croissant pas sur la région diélectrique.

A titre d'exemple, le matériau composant les plots de germination 24 peut être un nitrure, un carbure ou un borure d'un métal de transition de la colonne IV, V ou VI du tableau périodique des éléments ou une combinaison de ces composés. A titre d'exemple, les plots de germination 24 peuvent être en nitrure d'aluminium (AIN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN) ou en une combinaison de ceux-ci. Les plots de germination 24 peuvent être dopés du même type de conductivité que le substrat 10 ou du type de conductivité opposé.

La couche isolante 32 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxyde d'aluminium (Al₂O₃), en oxyde d'hafnium (HfO₂) ou en diamant. A titre d'exemple, l'épaisseur de la couche isolante 32 est comprise entre 5 nm et 5 µm, par exemple égale à environ 1 µm.

Les fils 26 peuvent être, au moins en partie, formés à partir d'au moins un matériau semiconducteur. Le matériau semiconducteur peut être du silicium, du germanium, du carbure de silicium, un composé III-V, un composé II-VI ou une combinaison de ces composés.

Les fils 26 peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils 26 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Les fils 26 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

La section droite des fils 26 peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil. Le diamètre moyen de chaque fil 26 peut être compris entre 50 nm et 2,5 µm. La hauteur de chaque fil 26 peut être comprise entre 250 nm et 50 µm.

Chaque fil 26 peut avoir une structure semiconductrice allongée selon un axe D sensiblement perpendiculaire à la face 12. Chaque fil 26 peut avoir une forme générale cylindrique. Les axes de deux fils 26 adjacents peuvent être distants de 0,1 µm à 10 µm et de préférence de 1,5 µm à 4 µm. A titre d'exemple, les fils 26 peuvent être régulièrement répartis. A titre d'exemple, les fils 26 peuvent être répartis selon un réseau hexagonal.

A titre d'exemple, la portion inférieure 28 de chaque fil 26 est principalement constituée du composé III-N, par exemple du nitrure de gallium, dopé du premier type de conductivité, par exemple au silicium. La portion inférieure 28 s'étend sur une hauteur qui peut être comprise entre 100 nm et 25 µm.

A titre d'exemple, la portion supérieure 30 de chaque fil 26 est au moins partiellement réalisée dans un composé III-N, par exemple du GaN. La portion supérieure 30 peut être dopée du premier type de conductivité, ou ne pas être intentionnellement dopée. La portion supérieure 30 s'étend sur une hauteur qui peut être comprise entre 100 nm et 25 µm.

Dans le cas d'un fil 26 composé principalement de GaN, la structure cristalline du fil 26 peut être du type wurtzite, le fil s'étendant selon l'axe D. La structure cristalline du fil 26 peut également être du type cubique.

La coque 34 peut comprendre un empilement d'une couche active recouvrant la portion supérieure 30 du fil 26, et éventuellement également en totalité ou en partie la portion inférieure 28, associé et d'une couche de liaison entre la couche active et l'électrode 36.

La couche active est la couche depuis laquelle est émise la majorité du rayonnement fourni par la diode électroluminescente DEL. Selon un exemple, la couche active peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche de liaison peut correspondre à une couche semiconductrice ou à l'empilement de couches semiconductrices et permet la formation d'une jonction P-N ou P-I-N avec la couche active et/ou la portion supérieure 30. Elle permet l'injection de trous dans la couche active via l'électrode 36. L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et une couche supplémentaire, pour assurer un bon contact électrique entre l'électrode 36 et la couche active, par exemple en nitrure de gallium (GaN) en contact avec la couche de blocage d'électrons et avec l'électrode 36. La couche de liaison peut être dopée du type de conductivité opposé à celui de la portion 30, par exemple dopée de type P.

L'électrode 36 est adaptée à polariser la couche active de chaque fil 26 et laisser passer le rayonnement électromagnétique émis par les diodes électroluminescentes DEL. Le matériau formant l'électrode 36 peut être un matériau transparent et conducteur tel que de l'oxyde d'indium-étain (ou ITO, acronyme anglais pour Indium Tin Oxide), de l'oxyde de zinc dopé à l'aluminium, de l'oxyde de zinc dopé au gallium, ou du graphène. A titre d'exemple, la couche d'électrode 36 a une épaisseur comprise entre 10 nm et 300 nm en fonction de la longueur d'onde d'émission souhaitée.

La couche conductrice 38 peut être une couche unique ou correspondre à un empilement de deux couches ou de plus de deux couches. La couche conductrice 38 peut, en outre, être adaptée à réfléchir au moins en partie le rayonnement émis par les diodes électroluminescentes DEL. A titre d'exemple, la couche conductrice 38 correspond à une monocouche métallique. Selon un autre exemple, la couche conductrice 38 correspond à un empilement de couches comprenant, par exemple, une couche métallique recouverte d'une couche diélectrique ou de plusieurs couches diélectriques. La couche métallique de la couche conductrice 38 peut être formée sur une couche d'accroche, par exemple en titane. A titre d'exemple, le matériau composant la couche métallique de la couche conductrice 38 (monocouche ou multicouche) peut être l'aluminium, un alliage à base d'aluminium, notamment AlSi_{z}, AlₓCu_{y} (par exemple avec x égal à 1 et y égal à 0,8 %), l'argent, l'or, le nickel, le chrome, le rhodium, le ruthénium, le palladium ou un alliage de deux de ces composés ou de plus de deux de ces composés. A titre d'exemple, la couche conductrice 38 (monocouche ou multicouche) a une épaisseur comprise entre 100 nm et 2000 nm.

La couche d'encapsulation 40 peut avoir une structure monocouche ou multicouche. Selon un mode de réalisation, la couche d'encapsulation 40 comprend au moins une couche déposée par un procédé de dépôt conforme. Selon un mode de réalisation, la couche d'encapsulation 40 comprend au moins une première couche déposée par un procédé de dépôt conforme et au contact de la couche conductrice 38 et de la couche d'électrode 36, et au moins une deuxième couche de remplissage des espaces entre les diodes électroluminescentes de façon à obtenir une face avant sensiblement plane.

La couche d'encapsulation 40, ou au moins l'une des couches qui la compose lorsque la couche d'encapsulation 40 a une structure multicouche, peut en outre comprendre un matériau photoluminescent adapté, lorsqu'il est excité par la lumière émise par les diodes électroluminescentes, à émettre de la lumière à une longueur d'onde différente de la longueur d'onde de la lumière émise par les diodes électroluminescentes.

L'épaisseur maximale de la couche d'encapsulation 40 est comprise entre 1 µm et 1000 µm, par exemple d'environ 30 µm, de sorte que la couche d'encapsulation 40 recouvre complètement l'électrode 36 au sommet des diodes électroluminescentes DEL. La couche d'encapsulation 40 est réalisée en un matériau ou des matériaux isolants au moins partiellement transparents. La couche d'encapsulation 40 peut être réalisée en un matériau ou des matériaux inorganiques au moins partiellement transparents. A titre d'exemple, le matériau inorganique est choisi parmi le groupe comprenant les oxydes de silicium du type SiOₓ où x est un nombre réel compris entre 1 et 2 ou SiO_{y}N_{z} où y et z sont des nombres réels compris entre 0 et 1 et les oxydes d'aluminium, par exemple Al₂O₃. La couche d'encapsulation 40 peut être réalisée en un matériau ou des matériaux organiques au moins partiellement transparents. A titre d'exemple, la couche d'encapsulation 40 est un polymère silicone, un polymère époxyde, un polymère acrylique ou un polycarbonate.

La figure 3 est une vue en coupe d'un mode de réalisation , ne faisant pas partie de l'invention telle que revendiquée, d'un dispositif optoélectronique 55. Le dispositif optoélectronique 55 comprend l'ensemble des éléments du dispositif optoélectronique 5 et comprend, en outre, pour chaque tranchée d'isolation électrique 16, une couche isolante électriquement 56 recouvrant les parois latérales 46 de la tranchée d'isolation électrique 16. Les couches isolantes 56 sont en un matériau isolant électriquement différent du matériau isolant composant les blocs isolants 42. Le matériau isolant composant les couches isolantes 56 peut être choisi parmi le groupe comprenant le SiO₂, le SiON, le SiN, l'AlN, le TiO₂, l'Al₂O₃ et les mélanges d'au moins deux de ces composés. Chaque couche isolante 56 a une épaisseur comprise entre 1 nm et 500 nm. De préférence, les couches isolantes 56 sont en oxyde de silicium obtenu par un procédé d'oxydation thermique ou par un procédé de dépôt de couche mince atomique (ALD, acronyme anglais pour Atomic Layer Déposition).

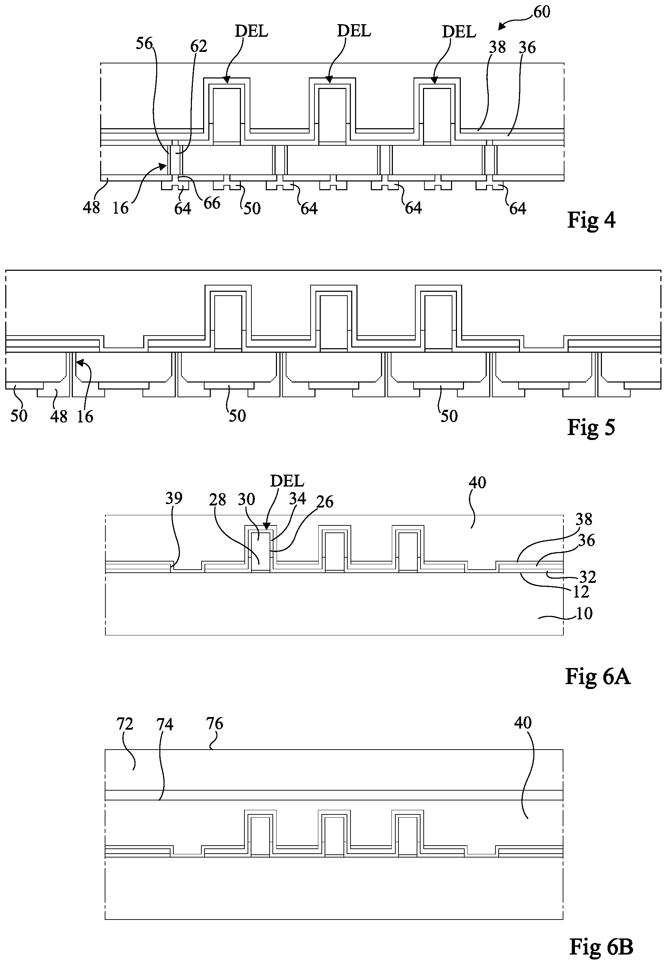

La figure 4 est une vue en coupe d'un mode de réalisation , ne faisant pas partie de l'invention telle que revendiquée, d'un dispositif optoélectronique 60. Le dispositif optoélectronique 60 comprend l'ensemble des éléments du dispositif optoélectronique 55 à la différence que les blocs isolants 42 sont remplacés par des éléments conducteurs électriquement 62 remplissant les tranchées 16. Les éléments conducteurs électriquement 62 sont en un matériau conducteur électriquement choisi parmi le groupe comprenant les métaux, notamment le cuivre (Cu) ou le tungstène (W), et le silicium polycristallin, éventuellement dopé.

Les éléments conducteurs 62 sont isolés électriquement du substrat 10 par les couches isolantes 56. Les éléments conducteurs 62 sont connectés à la couche d'électrode 36 ou la couche conductrice 38 des diodes électroluminescentes DEL. Le dispositif optoélectronique 60 comprend des plots conducteurs électriquement 64 au contact des éléments conducteurs 62 dans des ouvertures 66 formées dans la couche isolante 48. Les tranchées 16 jouent alors à la fois le rôle de tranchées d'isolation électrique isolant latéralement les portions 18 du substrat 10 et le rôle de vias traversants assurant une liaison électrique entre les faces 12 et 14 du substrat 10.

Un avantage des dispositifs optoélectroniques des figures 3 et 4 est qu'ils peuvent être utilisés avec des tensions élevées, par exemple entre 1,5 V et 400 V, en fonction de l'épaisseur de la couche d'oxyde thermique 56.

La figure 5 est une vue en coupe d'un mode de réalisation , ne faisant pas partie de l'invention telle que revendiquée, d'un dispositif optoélectronique 70. Le dispositif optoélectronique 70 comprend l'ensemble des éléments du dispositif optoélectronique 5 à la différence que la couche isolante 48 recouvre partiellement le pourtour des plots conducteurs 50.

Les figures 6A à 6F sont des coupes, partielles et schématiques, de structures obtenues à des étapes successives d'un mode de réalisation , ne faisant pas partie de l'invention telle que revendiquée, d'un procédé de fabrication du dispositif optoélectronique 5 représenté sur les figures 1 et 2.

La figure 6A représente la structure obtenue après la formation des diodes électroluminescentes DEL, de la couche isolante 32, de la couche d'électrode 36, des ouvertures 39 dans les couches 32 et 36, de la couche conductrice 38 et de la couche d'encapsulation 40 sur la face 12 du substrat 10.

L'épaisseur initiale du substrat 10 est supérieure à l'épaisseur finale visée. Le substrat 10 peut correspondre à une plaque de silicium monocristallin ayant une épaisseur initiale comprise entre 500 µm et 1500 µm, par exemple d'environ 725 µm et ayant un diamètre compris entre 100 mm et 450 mm, par exemple d'environ 200 mm ou 300 mm. De façon avantageuse, il s'agit d'une plaque de silicium habituellement utilisée dans les procédés de fabrication de circuits en microélectronique, notamment à base de transistors à effet de champ à grille métal-oxyde ou transistor MOS. A titre de variante, on peut utiliser tout autre semiconducteur monocristallin compatible avec les procédés de fabrication en microélectronique comme le germanium. De préférence, le substrat semiconducteur est dopé de façon à baisser la résistivité électrique du substrat à un niveau acceptable de résistance série de la diode électroluminescente et à une résistivité proche de celle des métaux, de préférence inférieure à quelques mohm.cm.

La formation des diodes électroluminescentes DEL peut comprendre les étapes décrites dans le brevet US9537044, et notamment la formation des plots de germination 24 sur la face 12 du substrat 10, la croissance des fils 26 sur les plots de germination 24 et la formation, pour chaque fil 26, des couches composant la coque 34. La couche isolante 32 peut être formée, par exemple par dépôt conforme d'une couche isolante sur la totalité de la structure et gravure de cette couche pour exposer la coque 34 de chaque fil 26. Dans le mode de réalisation décrit précédemment, la couche isolante 32 ne recouvre pas la coque 34. A titre de variante, la couche isolante 32 peut recouvrir une partie de coque 34. En outre, la couche isolante 32 peut être réalisée avant la formation de la coque 34.

L'électrode 36 est, par exemple, formée par dépôt conforme.

La couche conductrice 38 est, par exemple, formée par dépôt physique en phase vapeur (PVD, acronyme anglais pour Physical Vapor Déposition) sur l'ensemble de la structure obtenue à l'étape 7) et gravure de cette couche pour exposer chaque fil 26.

Lorsque la couche d'encapsulation 40 est réalisée en un matériau inorganique, elle peut être déposée par CVD basse température, notamment à une température inférieure à 300°C-400°C, par exemple par PECVD (acronyme anglais pour Plasma Enhanced Chemical Vapor Déposition). Lorsque la couche d'encapsulation 40 est en un matériau organique, elle peut être déposée par un procédé de dépôt à la tournette, par un procédé d'impression par jet, par un procédé de sérigraphie ou par un procédé de laminage d'un film. Un procédé de dispense par doseur temps/pression ou par doseur volumétrique est également possible en mode automatique sur des équipements programmables. La couche d'encapsulation 40 peut être formée sur la totalité du substrat 10.

La figure 6B représente la structure obtenue après la fixation de la structure représentée en figure 6A, du côté de la couche d'encapsulation 40, à un support supplémentaire 72, appelé poignée, éventuellement par l'intermédiaire d'une couche de colle 74. A titre d'exemple, la poignée 72 a une épaisseur comprise entre 100 µm et 1500 µm.

Selon un mode de réalisation, la poignée 72 est destinée à être conservée sur les dispositifs optoélectroniques une fois découpés. La poignée 72 est alors en un matériau au moins en partie transparent. Il peut s'agir de verre, notamment un verre borosilicate, par exemple du pyrex, ou de saphir. En outre, la couche 74 de colle est également en un matériau au moins en partie transparent. Un observateur perçoit les rayons lumineux émis par les diodes électroluminescentes DEL qui traversent la face 76 de la poignée 72 opposée à la couche d'encapsulation 40.

Selon un autre mode de réalisation, la poignée 72 est destinée à être retirée à une étape ultérieure du procédé de fabrication. Dans ce cas, la poignée 72 peut être réalisée en tout type de matériau compatible avec les étapes ultérieures du procédé de fabrication. Il peut s'agir de silicium ou tout substrat plan compatible avec les critères de planéité de la microélectronique.

La fixation de la poignée 72 à la couche d'encapsulation 40 peut être réalisée par tout moyen, par exemple par collage, par exemple en utilisant la couche 74 de colle organique réticulable en température, par exemple en un matériau thermoplastique ou thermodurcissable, ou bien encore par collage moléculaire (collage direct) ou collage optique par colle durcie aux rayonnements ultra-violet. Lorsque la couche d'encapsulation 40 est en un matériau organique, ce matériau peut servir de colle pour la poignée 72. Lorsqu'une couche de colle est employée, celle-ci doit être au moins partiellement transparente.

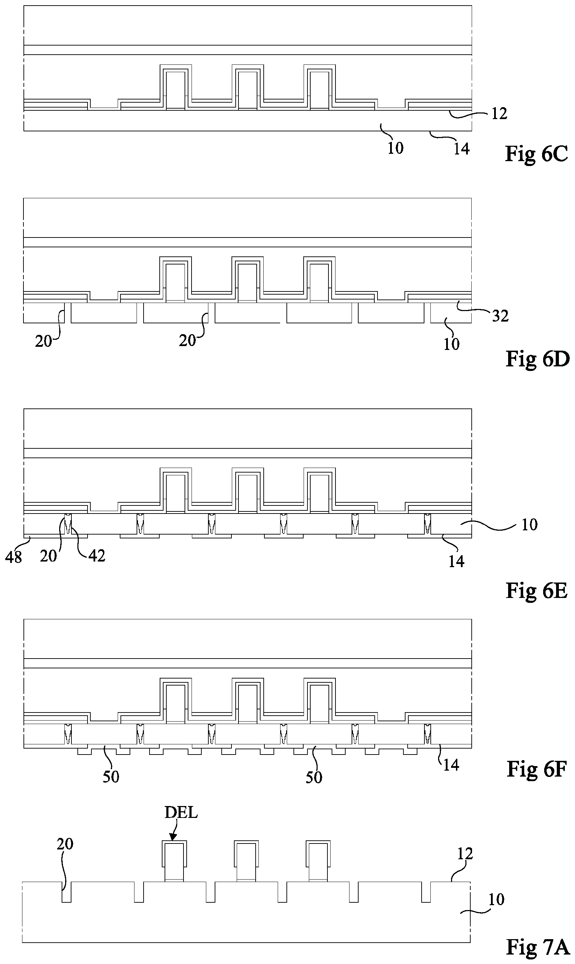

La figure 6C représente la structure obtenue après une étape d'amincissement du substrat 10. Après amincissement, l'épaisseur du substrat 10 peut être comprise entre 1 µm et 200 µm, par exemple d'environ 30 µm. L'étape d'amincissement peut être réalisée par une ou plus d'une étape de meulage, de gravure, et/ou par des procédés de planarisation mécano-chimique (CMP, acronyme anglais pour Chemical Mechanical Polishing). Le substrat 10 aminci comprend la face 14 opposée à la face 12. Les faces 12 et 14 sont de préférence parallèles.

La figure 6D représente la structure obtenue après la formation des ouvertures 20 traversant le substrat 10 et s'arrêtant sur la couche isolante 32. Les ouvertures 20 peuvent être formées par gravure du substrat 10. La gravure du substrat 10 peut être une gravure ionique réactive profonde (DRIE, acronyme anglais pour Deep Reactive Ion Etching).

La figure 6E représente la structure obtenue après la formation des blocs 42 dans les ouvertures 20, la formation de la couche isolante 48 sur la face arrière 14 du substrat aminci 10 et la gravure de la couche isolante 48 pour exposer des portions de la face arrière 14 du substrat 10. Il peut s'agir d'un dépôt qui conduit à un remplissage partiel des ouvertures 20, par exemple par PECVD. La gravure de la couche isolante 48 est aussi réalisée par gravure plasma avec la chimie adaptée à la couche isolante 48. Un avantage du procédé de fabrication est que les ouvertures 20 sont partiellement remplies par les blocs 42. Il y a donc moins de contraintes sur le procédé de dépôt mis en oeuvre pour former les blocs 42 et la couche isolante 48 et sur le rapport largeur/profondeur des ouvertures 20 puisqu'il n'est pas recherché un remplissage complet des ouvertures 20.

La figure 6F représente la structure obtenue après la formation des plots conducteurs 50 sur la face 14. Chaque plot conducteur 50 peut avoir une structure monocouche ou multicouche. Chaque plot conducteur 50 comprend par exemple une couche de TiCu ou de TiAl. Cette couche peut être recouverte d'une autre couche métallique, par exemple de l'or, du cuivre ou des alliages eutectiques (Ni/Au ou Sn/AG/Cu) en vue de la mise en oeuvre d'un procédé de brasage. Les plots conducteurs 50 peuvent être formés, notamment dans le cas du cuivre, par dépôt électrochimique (ECD, acronyme anglais pour Electro-Chemical Déposition). L'épaisseur des plots conducteurs 50 peut être comprise entre 0,1 µm et 30 µm, par exemple d'environ 1 µm.

Les figures 7A à 7G sont des coupes, partielles et schématiques, de structures obtenues à des étapes successives d'un mode de réalisation selon l'invention d'un procédé de fabrication du dispositif optoélectronique 55 représenté en figure 3.

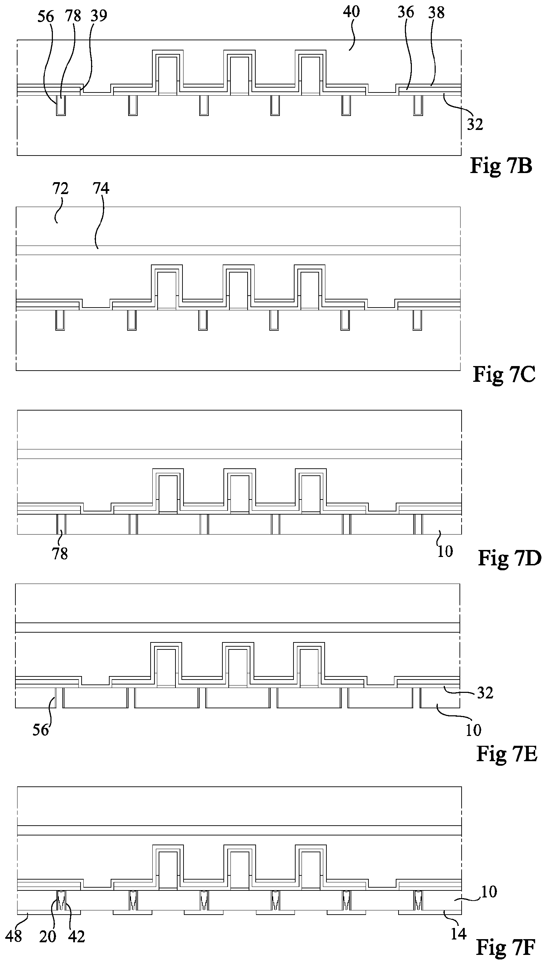

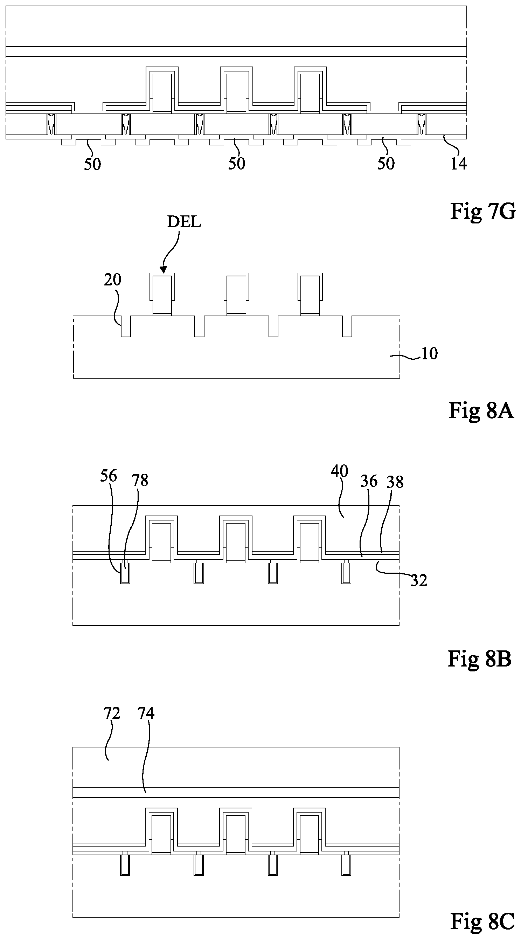

Le présent mode de réalisation du procédé de fabrication du dispositif optoélectronique 55 comprend les étapes suivantes :
formation des ouvertures 20 dans le substrat 10 du côté de la face avant 12 (figure 7A) avant la formation des diodes électroluminescente DEL et avant la formation de la couche isolante 32, de la couche d'électrode 36, de la couche conductrice 38 et de la couche d'encapsulation 40. Les ouvertures 20 peuvent être formées par une gravure du type DRIE. La profondeur de chaque ouverture 20 est strictement supérieure à l'épaisseur du substrat 10 après l'étape d'amincissement. A titre d'exemple, la profondeur de chaque ouverture 20 est comprise entre 1 µm et 200 µm, par exemple de l'ordre de 35 µm ;
formation des couches isolantes 56 dans les ouvertures 20, remplissage des ouvertures 20 par des éléments de remplissage 78, formation de la couche isolante 32, de la couche d'électrode 36, des ouvertures 39 dans les couches 32 et 36, de la couche conductrice 38 et de la couche d'encapsulation 40 (figure 7B). Un avantage du présent procédé de fabrication est que, les couches isolantes 56 étant formées dans les premières étapes du procédé de fabrication du dispositif optoélectronique 55, elles peuvent être fabriquées par un procédé qui nécessite l'application de températures élevées, par exemple supérieure à 700°C permettant d'obtenir un matériau ayant des propriétés d'isolation électrique améliorées. A titre d'exemple, les couches isolantes 56 peuvent être formées par oxydation thermique. Les couches isolantes 56 peuvent être présentes au fond des ouvertures 20. L'élément de remplissage 78 peut être en silicium polycristallin, dopé ou non dopé ou en métal, déposé par exemple par ALD ou ECD ;
fixation de la structure représentée en figure 7B à la poignée 72, éventuellement par l'intermédiaire de la couche de colle 74 (figure 7C), comme cela a été décrit précédemment en relation avec la figure 6B ;
amincissement du substrat 10 (figure 7D) comme cela a été décrit précédemment en relation avec la figure 6C jusqu'à exposer les éléments de remplissage 78 ;
retrait des éléments de remplissage 78 (figure 7E) par exemple par une gravure sélective par rapport aux matériaux composant le substrat 10, les couches isolantes 56 et la couche isolante 32, par exemple une gravure humide avec de l'hydroxyde de potassium (KOH) ou de l'hydroxyde de tétraméthylammonium (TMAH), ou une photolithogravure comprenant une étape de photolithographie et une étape de gravure humide ou sèche. Un avantage du présent mode de réalisation est que les contraintes mécaniques pouvant résulter de la présence des éléments de remplissage 78 sont supprimées ;
formation des blocs 42 dans les ouvertures 20 et formation de la couche isolante 48 sur la face arrière 14 du substrat aminci 10 et gravure de la couche isolante 48 pour exposer des portions de la face arrière 14 du substrat 10 (figure 7F) comme cela a été décrit précédemment en relation avec la figure 6E ; et
formation des plots conducteurs 50 (figure 7G) sur la face 14 comme cela a été décrit précédemment en relation avec la figure 6F.

Les figures 8A à 8G sont des coupes, partielles et schématiques, de structures obtenues à des étapes successives d'un mode de réalisation selon l'invention d'un procédé de fabrication du dispositif optoélectronique 60 représenté en figure 4.

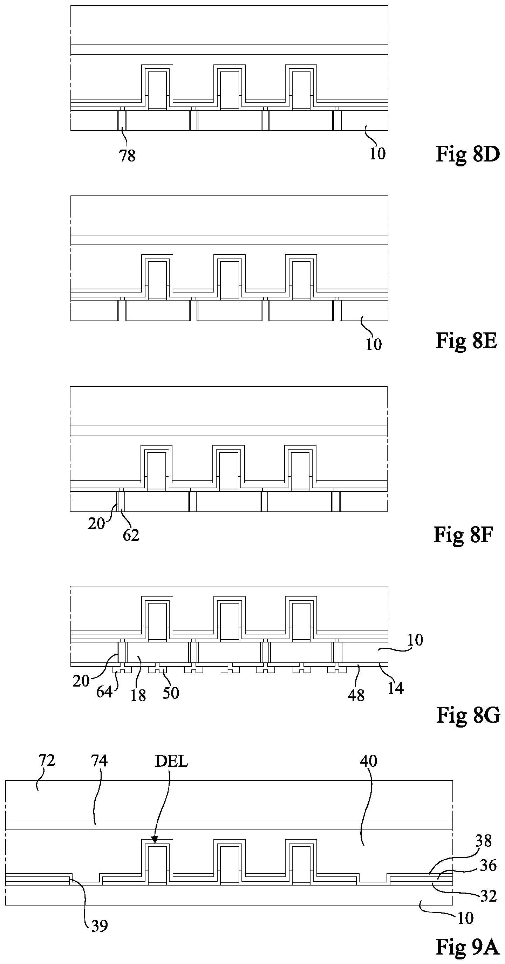

Le présent mode de réalisation du procédé de fabrication du dispositif optoélectronique 60 comprend les étapes suivantes :
formation des ouvertures 20 dans le substrat 10 (figure 8A) avant la formation des diodes électroluminescente DEL et avant la formation de la couche isolante 32, de la couche d'électrode 36, de la couche conductrice 38 et de la couche d'encapsulation 40 comme cela a été décrit précédemment en relation avec la figure 7A ;
formation des couches isolantes 56 dans les ouvertures 20, remplissage des ouvertures 20 par des éléments de remplissage 78, formation de la couche isolante 32, de la couche d'électrode 36 au contact des éléments de remplissage 78, de la couche conductrice 38 et de la couche d'encapsulation 40 (figure 8B) comme cela a été décrit précédemment en relation avec la figure 7B ;
fixation de la structure représentée en figure 8B à la poignée 72, éventuellement par l'intermédiaire de la couche de colle 74 (figure 8C), comme cela a été décrit précédemment en relation avec la figure 7C ;
amincissement du substrat 10 (figure 8D) comme cela a été décrit précédemment en relation avec la figure 7D jusqu'à exposer les éléments de remplissage 78 ;
retrait des éléments de remplissage 78 (figure 8E) comme cela a été décrit précédemment en relation avec la figure 7E ;
formation des blocs conducteurs 62 dans les ouvertures 20 par exemple Cu, Al ou Ti (figure 8F) ; et
formation de la couche isolante 48 sur la face arrière 14 du substrat aminci 10, gravure de la couche isolante 48 pour exposer des portions de la face arrière 14 du substrat 10 et formation des plots conducteurs 50 aux contact des portions de substrat 18 et des plots conducteurs 64 au contact des blocs conducteurs 62 (figure 8G).

A titre de variante ne faisant pas partie de l'invention telle que revendiquée, les étapes décrites précédemment en relation avec les figures 8E et 8F peuvent ne pas être présentes. Les blocs conducteurs 62 correspondent alors aux éléments de remplissage 78.

Les figures 9A à 9E sont des coupes, partielles et schématiques, de structures obtenues à des étapes successives d'un mode de réalisation , ne faisant pas partie de l'invention telle que revendiquée, d'un procédé de fabrication du dispositif optoélectronique 70 représenté en figure 5.

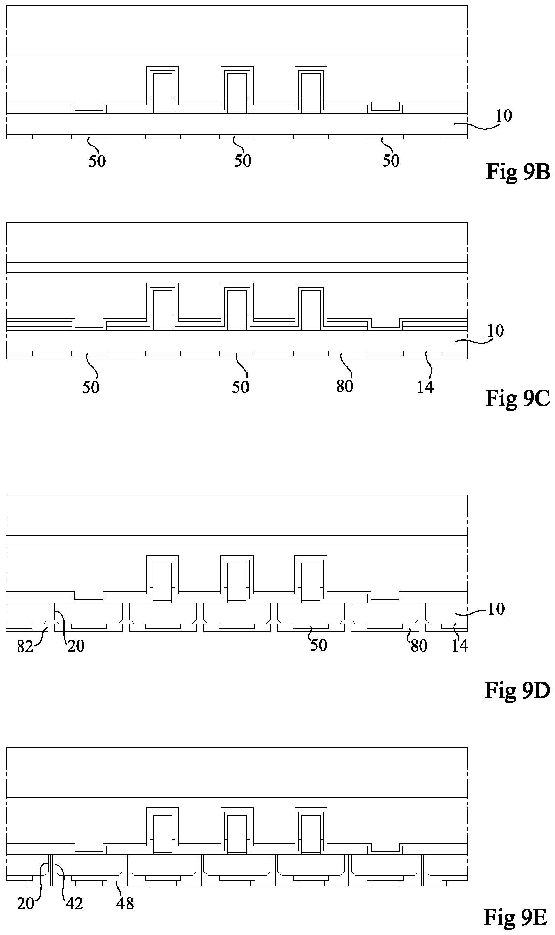

Le présent mode de réalisation du procédé de fabrication du dispositif optoélectronique 70 comprend les étapes suivantes :
formation des diodes électroluminescentes DEL, de la couche isolante 32, de la couche d'électrode 36, des ouvertures 39 dans les couches 32 et 36, de la couche conductrice 38 et la couche d'encapsulation 40, fixation de la structure obtenue à la poignée 72, par l'intermédiaire de la couche de colle 74 et amincissement du substrat 10 (figure 9A) comme cela a été décrit précédemment en relation avec les figures 6A à 6C ;
formation des plots conducteurs 50 sur la face arrière 14 (figure 9B). Un avantage du présent mode de réalisation est que les plots conducteurs 50 sont formées sur une surface 14 qui plane qui ne comprend pas d'ouvertures ;
formation d'une couche sacrificielle 80 (figure 9C), par exemple une couche métallique ou diélectrique d'un autre matériau que les plots conducteurs 50, la couche sacrificielle 80 recouvrant les plots conducteurs 50 et la face arrière 14 du substrat aminci 10 ;
gravure d'ouvertures 82 dans la couche sacrificielle 80 et gravure des ouvertures 20, dans le prolongement des ouvertures 82, traversant le substrat 10 et s'arrêtant sur la couche isolante 32 (figure 9D). La gravure de la couche sacrificielle 80 et du substrat 10 peut être une gravure DRIE ;
retrait de la couche sacrificielle 80 et formation des blocs isolants 42 dans les ouvertures 20, formation de la couche isolante 48 sur la face arrière 14 du substrat aminci 10 et gravure de la couche isolante 48 pour exposer des portions des plots conducteurs 50 (figure 9E). La formation des blocs isolants 42 et de la couche isolante 48 peut correspondre à un dépôt conforme qui conduit à un remplissage partiel des ouvertures 20.

Des modes de réalisation particuliers de la présente invention ont été décrits. Diverses variantes et modifications apparaîtront à l'homme de l'art. De plus, bien que, dans les modes de réalisation décrits précédemment, chaque fil 26 comprenne une portion passivée 28, à la base du fil en contact avec l'un des plots de germination 24, cette portion passivée 28 peut ne pas être présente.

En outre, bien que des modes de réalisation aient été décrits pour un dispositif optoélectronique pour lequel chaque diode électroluminescente comprend un élément semiconducteur tridimensionnel 26, notamment un fil, et la coque 34 qui recouvre le sommet du fil 26 et une partie des flancs latéraux du fil 26, il est clair que la structure des diodes électroluminescentes peut être différente. A titre d'exemple, chaque diode électroluminescente peut comprendre un élément semiconducteur tridimensionnel, notamment un fil, dont seul le sommet est recouvert par la coque. Selon l'invention, chaque diode électroluminescente comprend un élément semiconducteur filaire, conique ou tronconique

## Revendications

1. Procédé de fabrication d'un dispositif optoélectronique (5 ; 55 ; 60 ; 70) comprenant les étapes successives suivantes :
a) former un substrat (10) ayant une première face (12) ;
b) former des ouvertures (20) s'étendant dans le substrat (10) depuis la première face et entourant des portions (18) du substrat , les ouvertures à l'étape b) ne traversant pas complètement le substrat
c) former des diodes électroluminescentes (DEL) reposant sur la première face pour chaque portion du substrat, les diodes électroluminescentes (DEL) comprenant des éléments semiconducteurs (26) filaires, coniques ou tronconiques ;
d) former des couches isolantes (56) recouvrant les parois latérales des ouvertures (20), puis remplir chaque ouverture d'au moins un élément de remplissage (78), puis former une couche d'électrode (36) recouvrant au moins l'une des diodes électroluminescentes et une couche conductrice (38) recouvrant la couche d'électrode autour des diodes électroluminescentes ; et
e) former une couche (40) encapsulant les diodes électroluminescentes et recouvrant toute la première face ;
f) réduire l'épaisseur du substrat, le substrat comprenant, après l'étape f), une deuxième face (14) opposée à la première face (12), les ouvertures s'étendant, après l'étape f), de la première face à la deuxième face ;
g) retirer les éléments de remplissage ; et
h) former dans chaque ouverture au moins un bloc isolant électriquement (42) ou un élément conducteur électriquement (62) pour obtenir des tranchées d'isolation entourant les portions (18) du substrat et isolant électriquement les portions les unes des autres , chaque tranchée d'isolation étant remplie dudit au moins un bloc isolant électriquement (42) et d'un volume gazeux (44) ou dudit élément conducteur électriquement (62) isolé électriquement du substrat.

2. Procédé selon la revendication 1, dans lequel les éléments de remplissage (78) sont en silicium polycristallin, dopé ou non dopé, ou en métal.

3. Procédé selon l'une quelconque des revendications 1 à 2, dans lequel chaque tranchée d'isolation (16) comprend des faces latérales (46), le procédé comprenant la formation d'une couche isolante électriquement (56) recouvrant les faces latérales.

4. Procédé selon la revendication 3 , dans lequel chaque tranchée d'isolation (16) est au moins partiellement remplie par ledit au moins un bloc isolant électriquement (42), ledit au moins un bloc isolant électriquement et la couche isolante électriquement (56) étant constitués de matériaux différents.

5. Procédé selon l'une quelconque des revendications 1 à 3 , dans lequel chaque tranchée d'isolation (16) comprend ledit élément conducteur électriquement (62), les éléments conducteurs électriquement étant électriquement reliés, du côté de la première face (12), à la couche d'électrode (36) ou à la couche conductrice (38), le procédé comprenant la formation, sur la deuxième face (14), de deuxièmes plots conducteurs électriquement (64) reliés électriquement aux éléments conducteurs électriquement.

6. Procédé selon l'une quelconque des revendications 1 à 5, comprenant une étape de fixation d'un support (72) à la couche (40) encapsulant les diodes électroluminescentes (DEL).

7. Procédé selon l'une quelconque des revendications 1 à 6 , comprenant la formation, pour chaque portion (18) du substrat, d'au moins un premier plot conducteur (50) reposant sur la deuxième face (14) et en contact avec la portion (18) du substrat.

## Patentansprüche

1. Verfahren zur Herstellung einer optoelektronischen Vorrichtung (5; 55; 60; 70), das die folgenden aufeinanderfolgenden Schritte aufweist:
a) Bereitstellen eines Substrats (10) mit einer ersten Oberfläche (12);
b) Ausbilden von Öffnungen (20), die sich in dem Substrat (10) von der ersten Oberfläche aus erstrecken und Abschnitte (18) des Substrats umgeben, wobei die Öffnungen in Schritt b) das Substrat nicht vollständig durchqueren;
c) Ausbilden einer lichtemittierenden Diode (DEL), auf der ersten Oberfläche für jeden Abschnitt des Substrats, wobei die lichtemittierenden Dioden (DEL) drahtförmige, konische oder kegelstumpfförmige Halbleiterelemente (26) aufweisen;
d) Ausbilden von Isolierschichten (56), die die Seitenwände der Öffnungen (20) bedecken, dann Füllen jeder Öffnung mit mindestens einem Füllelement (78), dann Ausbilden einer Elektrodenschicht (36), die mindestens eine der lichtemittierenden Dioden bedeckt, und einer leitenden Schicht (38), die die Elektrodenschicht um die lichtemittierenden Dioden herum bedeckt; und
e) Ausbilden einer Schicht (40), die die lichtemittierenden Dioden einkapselt und die gesamte erste Oberfläche bedeckt;
f) Verringern der Dicke des Substrats, wobei das Substrat nach Schritt f) eine zweite Oberfläche (14) entgegengesetzt zur ersten Oberfläche (12) aufweist, wobei sich die Öffnungen nach Schritt f) von der ersten Oberfläche zu der zweiten Oberfläche erstrecken
g) Herausziehen der Füllelemente; und
h) Ausbilden mindestens eines elektrisch isolierenden Blocks (42) oder eines elektrisch leitenden Elements (62) in jeder Öffnung, um Isolationsgräben zu erhalten, die die Abschnitte (18) des Substrats umgeben und die Abschnitte voneinander elektrisch isolieren, wobei jeder Isolationsgraben mit dem elektrisch isolierenden Block (42) und einem gasförmigen Volumen (44) oder dem elektrisch leitenden Element (62) gefüllt ist, das vom Substrat elektrisch isoliert ist.

2. Verfahren nach Anspruch 1, bei dem die Füllelemente (78) aus polykristallinem Silizium, dotiert oder undotiert, oder aus Metall hergestellt sind.

3. Verfahren nach einem der Ansprüche 1 bis 2, wobei jeder Isolationsgraben (16) Seitenwände (46) aufweist, wobei das Verfahren das Ausbilden einer elektrisch isolierenden Schicht (56) aufweist, die die Seitenwände bedeckt.

4. Verfahren nach Anspruch 3, wobei jeder Isolationsgraben (16) zumindest teilweise durch den mindestens einen elektrisch isolierenden Block (42) ausgefüllt wird, wobei der mindestens eine elektrisch isolierende Block und die elektrisch isolierende Schicht (56) aus unterschiedlichen Materialien bestehen.

5. Verfahren nach einem der Ansprüche 1 bis 3, wobei jeder Isolationsgraben (16) das elektrisch leitende Element (62) aufweist, wobei die elektrisch leitenden Elemente auf der Seite der ersten Oberfläche (12) mit der Elektrodenschicht (36) oder der leitenden Schicht (38) elektrisch verbunden sind, wobei das Verfahren das Ausbilden von zweiten elektrisch leitenden Flächen (64) auf der zweiten Oberfläche (14) aufweist, die mit den elektrisch leitenden Elementen elektrisch verbunden sind.

6. Verfahren nach einem der Ansprüche 1 bis 5, das einen Schritt der Befestigung eines Trägers (72) an der Schicht (40) aufweist, die die Leuchtdioden (DEL) einkapselt.

7. Verfahren nach einem der Ansprüche 1 bis 6, das für jeden Abschnitt (18) des Substrats das Ausbilden mindestens einer ersten leitenden Kontaktfläche (50) aufweist, die auf der zweiten Oberfläche (14) aufliegt und in Kontakt mit dem Abschnitt (18) des Substrats steht.

## Claims

1. A method of manufacturing an optoelectronic device (5; 55; 60 ; 70) comprising the following successive steps:
a) providing a substrate (10) having a first surface (12) ;
b) forming openings (20) extending in the substrate (10) from the first surface and surrounding portions (18) of the substrate, the openings in step b) not completely crossing the substrate;
c) forming one light-emitting diodes (DEL) resting on the first surface for each portion of the substrate, the light-emitting diodes (DEL) comprising wired, conical, or frustoconical semiconductor elements (26);
d) forming insulating layers (56) covering the lateral walls of the openings (20), then filling each opening with at least one filling element (78), then forming an electrode layer (36) covering at least one of the light-emitting diodes and a conductive layer (38) covering the electrode layer around the light-emitting diodes; and
e) forming a layer (40) encapsulating the light-emitting diodes and covering the entire first surface;
f) reducing the thickness of the substrate, the substrate comprising, after step f), a second surface (14) opposite the first surface (12), the openings extending, after step f), from the first surface to the second surface
g) withdrawing the filling elements; and
h) forming in each opening at least one electrically insulating block (42) or one electrically conductive element (62) to obtain insulation trenches surrounding the portions (18) of the substrate and electrically insulating the portions from each other, each insulation trench being filled with said electrically insulating block (42) and a gaseous volume (44) or said electrically conductive element (62) electrically isolated from the substrate.

2. The method of claim 1, wherein the filling elements (78) are made of polycrystalline silicon, doped or undoped, or of metal.

3. The method of any one of claims 1 to 2, wherein each insulation trench (16) comprises side walls (46), the method comprising forming an electrically insulating layer (56) covering the side walls.

4. The method of claim 3, wherein each insulation trench (16) is at least partially filled by said at least one electrically insulating block (42), said at least one electrically insulating block and the electrically insulating layer (56) being made of different materials.

5. The method of any one of claims 1 to 3, wherein each insulation trench (16) comprises said electrically conductive element (62), the electrically conductive elements being electrically connected, on the side of the first surface (12), to the electrode layer (36) or the conductive layer (38), the method comprising forming, on the second surface (14), second electrically conductive pads (64) electrically connected to the electrically conductive elements.

6. The method according to any one of claims 1 to 5, comprising a step of fixing a support (72) to the layer (40) encapsulating the light-emitting diodes (DEL).

7. The method according to any one of claims 1 to 6, comprising forming, for each portion (18) of the substrate, at least a first conductive pad (50) resting on the second surface (14) and in contact with the portion (18) of the substrate.
